# EUROPÄISCHE PATENTSCHRIFT

(11) **EP 1 124 232 B1**
(45) Veröffentlichungstag und Bekanntmachung des Hinweises auf die Patenterteilung: **16.04.2008**
(21) Anmeldenummer: 01101730.8
(22) Anmeldetag: 25.01.2001
(51) Int. Cl.: G11C 29/00

(54) **Integrierter Halbleiterspeicher mit redundanter Einheit von Speicherzellen**
Integrated semiconductor memory with redundant cells
Mémoire de semiconducteur intégrée avec l'unité redondante des cellules de mémoire

(30) Priorität: 09.02.2000 DE 10005618
(43) Veröffentlichungstag der Anmeldung: 16.08.2001
(73) Patentinhaber: Infineon Technologies AG, 81669 München (DE)
(72) Erfinder: Böhm, Thomas, 85604 Zorneding (DE); Hönigschmid, Heinz, East Fishkill, NY 12524 (US); Lammers, Stefan, 81739 München (DE); Manyoki, Zoltan, CDN-Kanada, ON K2L 3W9 (CA)
(74) Vertreter: Epping - Hermann - Fischer

(56) Entgegenhaltungen:
- EP-A- 0 702 373
- US-A- 5 732 029
- US-A- 6 023 433

## Beschreibung

Die vorliegende Erfindung betrifft einen integrierten Halbleiterspeicher mit Speicherzellen, die zu adressierbaren normalen Einheiten und zu wenigstens einer redundanten Einheit zum Ersetzen einer der normalen Einheiten zusammengefaßt sind, mit einem Adreßbus, auf dem eine Adresse anlegbar ist, und mit einer Redundanzschaltung, die mit dem Adreßbus verbunden ist, zur Auswahl der redundanten Einheit.

Integrierte Halbleiterspeicher weisen im allgemeinen zur Reparatur fehlerhafter Speicherzellen redundante Einheiten von Speicherzellen auf, die normale Einheiten von Speicherzellen mit defekten Speicherzellen adressenmäßig ersetzen können. Dabei wird der integrierte Speicher beispielsweise mit einer externen Prüfeinrichtung oder einer Selbsttesteinrichtung geprüft und anschließend eine Programmierung der redundanten Elemente vorgenommen. Eine Redundanzschaltung weist dann programmierbare Elemente zum Beispiel in Form von Laser Fuses oder elektrisch programmierbaren Fuses auf, die zum Speichern der Adresse einer zu ersetzenden Einheit dienen. Sie werden beispielsweise im Laufe des Herstellungsprozesses des Speichers mittels eines Laserstrahls beziehungsweise einer sogenannten Brennspannung programmiert.

Im Betrieb eines Halbleiterspeichers werden im Zuge eines Speicherzugriffs die zu ersetzenden normalen Einheiten durch die entsprechenden redundanten Einheiten adressenmäßig ersetzt. Zu Beginn eines Speicherzugriffs wird eine Redundanzauswertung in den Redundanzschaltungen innerhalb eines ausgewählten Speicherbereichs durchgeführt. Dazu wird beispielsweise eine Adresse der ausgewählten normalen Einheit auf einem Adreßbus angelegt, woraufhin ein Vergleich der angelegten Adresse mit einer in der jeweiligen Redundanzschaltung gespeicherten Adresse einer defekten normalen Einheit erfolgt. Jede der Redundanzschaltungen liefert im Anschluß an den Vergleich ein Signal, das Information darüber gibt, ob die angelegte Adresse mit der in der jeweiligen Redundanzschaltung gespeicherten Adresse übereinstimmt. Bei einer Übereinstimmung wird durch die entsprechende Redundanzschaltung die zugehörige redundante Einheit ausgewählt.

Damit fehlerhafte normale Einheiten von Speicherzellen eines Halbleiterspeichers nur durch fehlerfreie redundante Einheiten ersetzt werden, ist es zweckmäßig, daß neben den normalen Einheiten von Speicherzellen auch die redundanten Einheiten von Speicherzellen hinsichtlich Fehlerfreiheit getestet werden. Ein derartiger Test sollte durchgeführt werden bevor die programmierbaren Elemente der Redundanzschaltungen beispielsweise durch einen Laser programmiert werden. Zur Durchführung des Testbetriebs ist im allgemeinen ein zusätzlicher Schaltungsaufwand auf dem Halbleiterspeicher notwendig. Dabei ist es günstig, daß dieser zusätzlich benötigte Schaltungsaufwand im Interesse eines geringen Platzbedarfs auf dem Halbleiterspeicher vergleichsweise gering ist.

Die Druckschrift US 5,732,029 betrifft ein Verfahren und eine Schaltung zum Testen von Speicherzellen eines Halbleiterspeichers. Die Speicherzellen sind als normale Einheiten und als redundante Einheiten in einem Speicherzellenfeld angeordnet. Im Normalbetrieb wird eine an die Adressanschlüsse angelegte Adresse in einer Redundanz-Fuse-Schaltung mit einer einprogrammierten Adresse einer fehlerhaften Einheit der Speicherzellen verglichen. Bei Übereinstimmung beider Adressen wird anstelle der normalen Einheit eine der redundanten Einheiten ausgewählt. Die Auswahl einer der normalen Speicherzellen erfolgt durch Ansteuerung eines Spalten- und Zeilendekoders mit einem Adresssignal. Die Auswahl einer der redundanten Speicherzellen erfolgt durch Ansteuerung eines Redundanzspalten- und Redundanzzeilendekoders. Um durch Anlegen einer Adresse sowohl auf die normalen Einheiten als auch auf die redundanten Einheiten zugreifen zu können, wird der Adressbus um eine zusätzliche Leitung erweitert, um ein zusätzliches Adresssignal an den Halbleiterspeicher anzulegen. In Abhängigkeit von einem Low- oder High-Pegel des zusätzlichen Adresssignals wird über die Spalten- und Zeilendekoder beziehungsweise über die Redundanzspalten- und Redundanzzeilendekoder eine der normalen Speicherzellen oder eine der redundanten Speicherzellen ausgewählt.

Die Aufgabe der vorliegenden Erfindung ist es, einen integrierten Halbleiterspeicher der eingangs genannten Art anzugeben, bei dem das Testen einer redundanten Einheit von Speicherzellen möglich ist und bei dem der dazu benötigte Schaltungsaufwand gering ist.

Die Aufgabe wird gelöst durch einen integrierten Halbleiterspeicher mit Speicherzellen, die zu adressierbaren normalen Einheiten zusammengefasst sind, mit mehreren redundanten Einheiten zum Ersetzen von normalen Einheiten, mit einem Adressbus, auf dem eine Adresse anlegbar ist, die mehrere Adressbits umfasst, wobei der Adressbus mehrere Anschlüsse für jeweils eines der Adressbits umfasst, und mit mehreren Redundanzschaltungen, wobei jede der Redundanzschaltungen jeweils einer der redundanten Einheiten zugeordnet ist. Die mehreren Redundanzschaltungen sind jeweils zum Speichern einer Adresse der durch die jeweilige redundante Einheit zu ersetzenden normalen Einheit, zum Vergleichen der auf dem Adressbus anliegenden Adresse mit der gespeicherten Adresse und zur Aus wahl der jeweiligen redundanten Einheit bei festgestellter Übereinstimmung mit dem Adressbus verbunden. Des Weiteren weist jede der Redundanzschaltungen mehrere Eingänge für jeweils eines der Adressbits auf. Jeder der Redundanzschaltungen ist jeweils eine Verarbeitungseinheit zugeordnet, wobei jede der Verarbeitungseinheiten eingangsseitig mit einem unterschiedlichen Anschluss des Adressbusses und mit einem Anschluss für ein Testsignal verbunden ist und ausgangsseitig mit einem unterschiedlichen Eingang der Redundanzschaltungen verbunden ist, wobei die jeweilige Verarbeitungseinheit das ihr über den Anschluss des Adressbusses zugeführte Adresssignal nur bei einem definierten Zustand des Testsignals verändert.

Bei dem erfindungsgemäßen Halbleiterspeicher werden vorhandene Adreßleitungen benutzt, um die redundante Einheit von Speicherzellen während eines Testbetriebs zu selektieren. Bei einem derartigen Redundanz-Testkonzept wird beispielsweise kein zusätzlicher Decoder und keine zusätzliche Auswahlleitung benötigt, der die redundante Einheit von Speicherzellen auswählt. Zur Auswahl der redundanten Einheit im Testbetrieb wird neben den Adreßleitungen die ebenfalls vorhandene Redundanzschaltung verwendet. Diese ist zum Testen der redundanten Einheit (noch) nicht programmiert. Die der Redundanzschaltung vorgeschaltete Verarbeitungseinheit verändert ein anliegendes Adreßsignal am Eingang der Redundanzschaltung im Normalbetrieb nicht. Durch ein entsprechendes Testsignal wird ein Adreßsignal nur im Testbetrieb verändert. Die Verarbeitungseinheit kann in einer einfachen Ausführung beispielsweise als logisches Gatter ausgeführt werden. Der für den Testbetrieb zusätzlich benötigte Schaltungsaufwand ist damit vergleichsweise gering.

Die Erfindung eignet sich für beliebige Halbleiterspeicher, bei denen eine Reparatur von defekten Einheiten von Speicher zellen durch redundante Einheiten von Speicherzellen erfolgt. Bei den normalen Einheiten handelt es sich beispielsweise um reguläre Wort- oder Bitleitungen, bei den redundanten Einheiten um redundante Wort- oder Bitleitungen. Es besteht jedoch auch die Möglichkeit, statt einzelner Wort- oder Bitleitungen größere Einheiten von Speicherzellen, beispielsweise einzelne Speicherzellenblöcke, durch entsprechende redundante Einheiten zu ersetzen.

Vorteilhafte Aus- und Weiterbildungen sind Gegenstand abhängiger Ansprüche.

Der erfindungsgemäße integrierte Halbleiterspeicher, dessen Funktionsweise im Testbetrieb und dessen vorteilhafte Aus- und Weiterbildungen werden im folgenden anhand der in der Zeichnung dargestellten Figuren näher erläutert. Es zeigen:
- Figur 1: eine schematische Darstellung eines matrixförmigen Speicherzellenfeldes,
- Figur 2: eine Ausführungsform eines erfindungsgemäßen Halbleiterspeichers,
- Figur 3: eine Ausführungsform einer Redundanzschaltung aus Figur 2,
- Figur 4: eine Ausführungsform einer Speicherschaltung aus Figur 3.

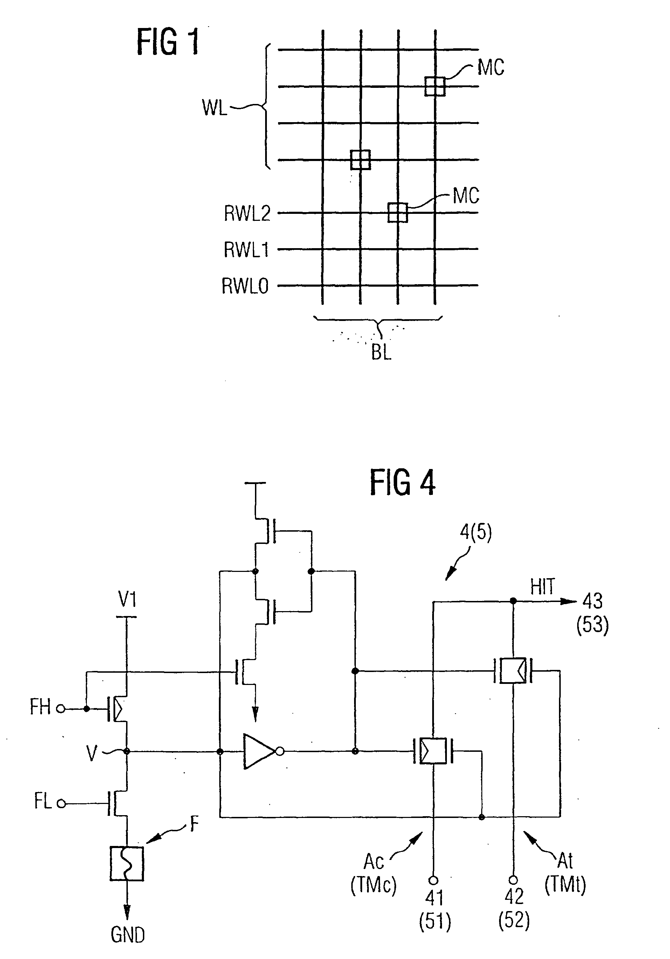

Figur 1 ist ein matrixförmig organisiertes Speicherzellenfeld beispielsweise eines DRAM zu entnehmen, das reguläre Wortleitungen WL und Bitleitungen BL aufweist, in deren Kreuzungspunkten Speicherzellen MC angeordnet sind. Weiterhin weist das Speicherzellenfeld redundante Wortleitungen RWL0 bis RWL2 auf, in deren Kreuzungspunkten mit den Bitleitungen BL ebenfalls Speicherzellen MC angeordnet sind.

Die Erfindung ist auf einen Halbleiterspeicher anwendbar, der nur eine redundante Leitung, beispielsweise RWL1, aufweist. In der Praxis weist ein Halbleiterspeicher im allgemeinen mehrere redundante Leitungen auf. Zum besseren Verständnis wird die Erfindung zunächst nur hauptsächlich bezüglich der redundanten Wortleitung RWL1 erläutert. Die Erfindung ist entsprechend auf die weiteren redundanten Wortleitungen RWL0 und RWL2 anwendbar.

Die Speicherzellen MC des gezeigten Speichers beinhalten jeweils einen Auswahltransistor und einen Speicherkondensator. Dabei sind Steuereingänge der Auswahltransistoren mit einer der Wortleitungen WL beziehungsweise redundanten Wortleitungen RWL0 bis RWL2 verbunden, während ein Hauptstrompfad der Auswahltransistoren zwischen dem Speicherkondensator der jeweiligen Speicherzelle MC und einer der Bitleitungen BL angeordnet ist.

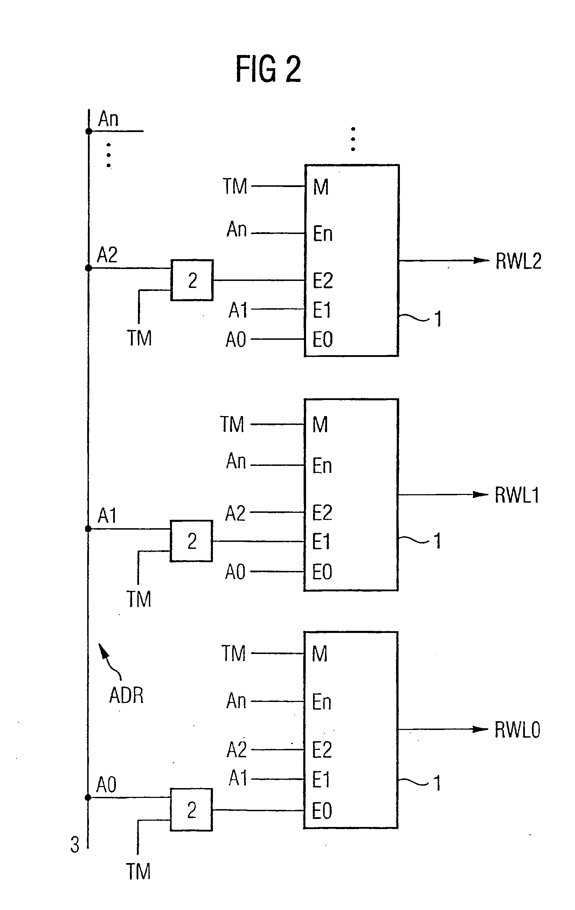

Figur 2 zeigt eine Ausführungsform eines erfindungsgemäßen Halbleiterspeichers. Dieser weist einen Adreßbus 3 auf, auf dem eine Adresse ADR anlegbar ist. Weiterhin weist der Halbleiterspeicher wenigstens eine Redundanzschaltung 1 zur Auswahl der redundanten Leitung RWL1 auf, die mit dem Adreßbus 3 verbunden ist.

In der Redundanzschaltung 1 ist für den Normalbetrieb des Halbleiterspeichers beispielsweise eine Adresse einer durch die redundante Leitung RWL1 zu ersetzenden regulären Leitung WL gespeichert. Bei einem Speicherzugriff wird eine an dem Adreßbus 3 anliegende Adresse ADR mit der in der Redundanzschaltung 1 gespeicherten Adresse verglichen. Bei Übereinstimmung der gespeicherten Adresse mit der auf dem Adreßbus 3 anliegenden Adresse ADR wird die betreffende redundante Leitung RWL1 ausgewählt. Das bedeutet, die Wortleitung WL mit der auf dem Adreßbus 3 anliegenden Adresse ADR wird durch die redundante Wortleitung RWL1 adressenmäßig ersetzt.

Der integrierte Halbleiterspeicher aus Figur 2 weist weiterhin eine Verarbeitungseinheit 2 auf, die eingangsseitig mit einem Anschluß A1 des Adreßbusses und mit einen Anschluß für ein Testsignal TM verbunden ist. Ausgangsseitig ist die Verarbeitungseinheit 2 mit einem Eingang E1 der Redundanzschaltung 1 verbunden.

Beispielsweise umfaßt die auf dem Adreßbus 3 anliegende Adresse ADR mehrere Adreßbits. Dementsprechend weist der Adreßbus 3 mehrere Anschlüsse A0 bis An auf für jeweils ein Adreßbit. Ebenso weist die Resundanzschaltung 1 mehrere Eingänge E0 bis En auf für jeweils ein Adreßbit. Gemäß der Ausführungsform nach Figur 2 ist die Verarbeitungseinheit 2 dabei mit einem der Anschlüsse A0 bis An des Adreßbusses 3 und mit einem der Eingänge E0 bis En der Redundanzschaltung 1 verbunden. Weiterhin ist das Testsignal TM am Anschluß M der Redundanzschaltung 1 angeschlossen.

Bei mehreren zu testenden redundanten Wortleitungen RWL0 bis RWL2 ist den zugehörigen Redundanzschaltungen 1 dabei jeweils eine Verarbeitungseinheit 2 zugeordnet. Dabei ist es möglich, daß einer der Redundanzschaltungen 1 keine Verarbeitungseinheit 2 zugeordnet ist. Die Verarbeitungseinheiten 2 sind hier jeweils mit einem unterschiedlichen Anschluß A0 bis An des Adreßbusses 3 und jeweils mit einem unterschiedlichen Eingang E0 bis En der Redundanzschaltungen 1 verbunden.

Figur 4 zeigt eine Ausführungsform einer Speicherschaltung 4, die jeweils in einer der Redundanzschaltungen 1 enthalten ist. Die Speicherschaltung 4 weist ein programmierbares Element F in Form einer Laser Fuse F auf sowie ein sogenanntes Fuse-Latch in Form einer Halteschaltung bestehend aus zwei antiparallelen Invertern. Mit Hilfe des Signals FH wird über den PMOS-Transistor der Knoten V zunächst mit einem Wert "1", der beispielsweise dem Wert eines internen Versorgungspotentials V1 entspricht, vorbelegt. Durch eine anschließende Ansteuerung des NMOS-Transistors mit dem Signal FL wird der Knoten V abhängig vom Zustand der Fuse F auf den Wert "0", der beispielsweise einem Bezugspotential GND entspricht, zurückgesetzt, oder er wird im Zustand "1" belassen. Ist die Fuse F nicht durchtrennt, so wird der Knoten V auf das Bezugspotential GND zurückgesetzt. Ist die Fuse F hingegen durchtrennt (programmiert), so bleibt das Potential am Knoten V erhalten. In diesem Fall wird der Zustand "1" im Fuse-Latch gespeichert.

Die Speicherschaltung 4 weist weiterhin jeweils einen Eingang 42 für ein logisches Signal At und einen Eingang 41 für ein dazu komplementäres logisches Signal Ac auf. Weiterhin weist die Speicherschaltung 4 einen Ausgang 43 auf für ein Ausgangssignal HIT. Entsprechend der Schaltungsanordnung nach Figur 4 weist das Ausgangssignal HIT bei einem programmierten programmierbaren Element F (Zustand "1" im Fuse-Latch gespeichert) den Zustand des komplementären logischen Signals Ac auf. Entsprechend weist das Ausgangssignal HIT bei einem nicht programmierten programmierbaren Element F (Zustand "0" gleich dem Bezugspotential GND im Fuse-Latch gespeichert) den Zustand des logischen Signals At auf.

In der Speicherschaltung 4 ist im Normalbetrieb also mit dem Durchtrennen beziehungsweise Programmieren des programmierbaren Elements F die Reparatur-Information für ein Adreßbit gespeichert. An den Eingang 42 wird beispielsweise ein logisches Signal At in Form eines Adreßbits, an den Eingang 41 wird das dazu komplementäre logische Signal Ac in Form des invertierten Adreßbits angelegt. Stimmt die programmierte Reparatur-Information in dem Fuse-Latch mit dem angelegten Adreßbit überein, so weist das Ausgangssignal HIT beispielsweise einen aktiven Zustand auf. Bei der Annahme, daß die Fuse F durchtrennt beziehungsweise programmiert ist, weist das Ausgangssignal HIT bei einem Signal At = 1 den aktiven Zustand HIT = 0 auf. Das bedeutet, daß im Falle einer durchtrennten Fuse F das invertierte Adreßbit an den Ausgang 43 der Speicherschaltung 4 gelangt.

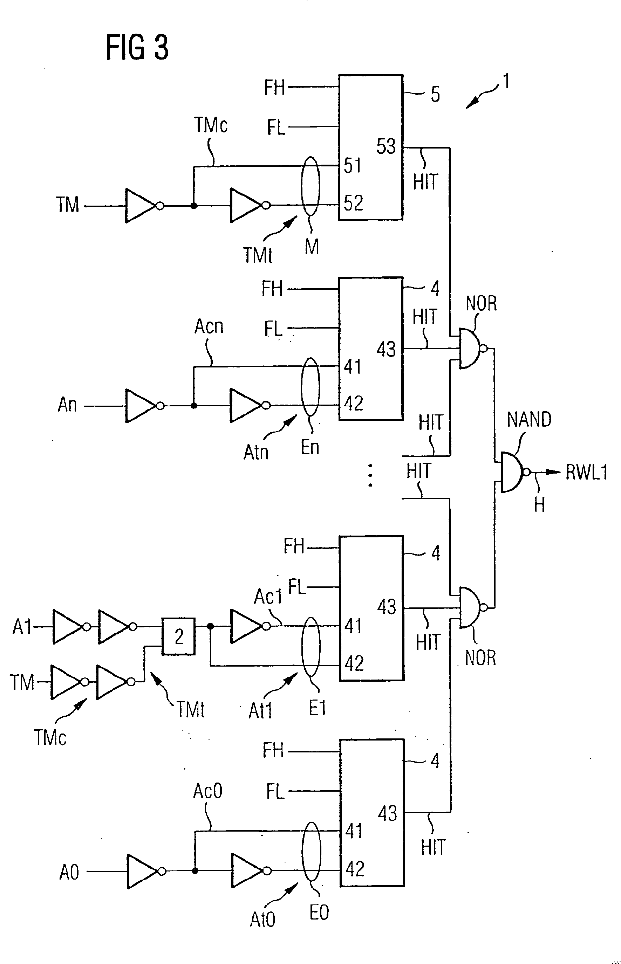

In Figur 3 ist eine Ausführungsform einer Redundanzschaltung 1 aus Figur 2 gezeigt. Die Redundanzschaltung 1 enthält Speicherschaltungen 4 entsprechend der Anzahl der Adreßbits. Dabei ist jeweils wenigstens der Eingang 42 an einem der Eingänge E0 bis En der Redundanzschaltung 1 angeschlossen. Der jeweilige Eingang 41 liegt an einem Anschluß mit dem jeweiligen dazu komplementären Signal an.

Die Redundanzschaltung 1 weist in einer Ausführungsform eine weitere Speicherschaltung 5 auf, die Information darüber enthält, ob die in den Speicherschaltungen 4 gespeicherte Information der Redundanzschaltung 1 gültig ist. Die weitere Speicherschaltung 5 ist dabei wie die Speicherschaltung 4 aus Figur 4 schaltungstechnisch aufgebaut. Der Eingang 52 liegt dabei an dem Testsignal TMt an, der Eingang 51 liegt an einem dazu komplementären Testsignal TMc an.

Die Speicherschaltung 5 wird auch als sogenanntes Master-Fuse-Latch bezeichnet. Es ist aktiviert, wenn die gespeicherte Reparatur-Information in der Redundanzschaltung 1 gültig ist. Das heißt, nur wenn alle Speicherschaltungen 4 inklusive der Speicherschaltung 5 ein aktives Ausgangssignal HIT = 0 aufweisen, ist die entsprechende redundante Leitung RWL0 bis RWL2 ausgewählt.

Im folgenden wird die Funktionsweise des erfindungsgemäßen Halbleiterspeichers gemäß den Ausführungsformen nach den Figuren 1 bis 4 während eines Testbetriebs näher erläutert.

Der Test beispielsweise der redundanten Leitung RWL1 findet statt, bevor die programmierbaren Elemente F der Speicherschaltungen 4 mit Hilfe eines Lasers programmiert werden. Das heißt, die Reparatur-Information ist noch nicht programmiert und dementsprechend auch die Speicherschaltung 5 (Master-Fuse-Latch) nicht programmiert. Um die Redundanzschaltung 1 zur Auswahl der redundanten Leitung RWL1 zu aktivieren, muß an allen Speicherschaltungen 4 der Redundanzschaltung 1 ein Signal At = 0 und damit das Signal Ac = 1 anliegen. Das bedeutet, an den Ausgängen 43 der Speicherschaltungen 4 weist das Ausgangssignal HIT jeweils den Zustand aktiven HIT = 0 auf. Weiterhin wird für den Testbetrieb das Testsignal TM = TMt = 0 und damit das Signal TMc = 1 angelegt. Damit weist auch der Ausgang 53 der Speicherschaltung 5 ein aktives Ausgangssignal HIT = 0 auf.

Um ausschließlich die Redundanzschaltung 1 zur Auswahl der redundanten Leitung RWL1 auszuwählen, wird eine entsprechende Adresse ADR auf dem Adreßbus 3 angelegt. Die Adresse ADR weist für die Adreßbits an den Anschlüssen A0 und A2 bis AN den Zustand "0" und für das Adreßbit an dem Anschluß A1 den Zustand "1" auf. Es liegt auf dem Adreßbus 3 also die Adresse ADR = 0...010 an. Mit einer XNOR-Verknüpfung in der Verarbeitungseinheit 2 wird aus dem Adreßbit an dem Anschluß A1 und dem Testsignal TM ein Ausgangssignal Atl mit dem Zustand "0" erzeugt. Das heißt, das Adreßbit am Anschluß A1 wird in der Verarbeitungseinheit 2 invertiert. Somit liegen an allen Eingängen 42 der Speicherschaltungen 4 Signale mit dem Zustand "0" an, woraufhin deren Ausgangssignale HIT = 0 aktiviert sind. Ebenso ist das Ausgangssignal HIT der Speicherschaltung 5 durch das Testsignal TMt = 0 aktiviert. Da alle Ausgangssignale HIT der Speicherschaltungen 4 beziehungsweise 5 aktiviert sind, wird die redundante Leitung RWL1 durch ein entsprechendes Signal H ausgewählt.

Da die jeweiligen Verarbeitungseinheiten 2 der jeweiligen Redundanzschaltungen 1 zur Auswahl unterschiedlicher redundanter Leitungen RWL0 bis RWL2 jeweils mit einem unterschiedlichen Anschluß A0 bis An des Adreßbusses 3 und jeweils mit einem unterschiedlichen Eingang E0 bis En der Redundanzschaltung 1 verbunden sind, wird mit der angelegten Adresse ADR ausschließlich die Redundanzschaltung 1 zur Auswahl der redundanten Leitung RWL1 für den Testbetrieb ausgewählt.

Ist für einen Normalbetrieb des integrierten Speichers eine Reparatur-Information in den Redundanzschaltungen 1 gespeichert, so kann durch das Testsignal TM die Auswahl der entsprechenden redundanten Leitung auch nach der Programmierung der Reparatur-Information abgeschaltet werden. Das programmierbare Element F der Speicherschaltung 5 ist mit dem Einschreiben der Reparatur-Information in die Redundanzschaltung 1 programmiert. Durch Anlegen eines Testsignals TMt = 0 am Eingang 52 beziehungsweise durch ein Anlegen des Testsignals TMc = 1 am Eingang 51 der Speicherschaltung 5 wird das Ausgangssignal HIT = 1 erzeugt. Dieses ist also in einem inaktiven Zustand. Damit wird kein Ausgangssignal H der Redundanzschaltung 1 erzeugt zur Auswahl einer der redundanten Leitungen RWL0 bis RWL2. Die entsprechende redundante Leitung kann also beispielsweise zu Testzwecken auch nach dem programmieren der Reparatur-Information deaktiviert werden.

## Patentansprüche

1. Integrierter Halbleiterspeicher
- mit Speicherzellen (MC), die zu adressierbaren normalen Einheiten (WL) zusammengefaßt sind,
- mit mehreren redundanten Einheiten (RWL0; RWL2) zum Ersetzen von normalen Einheiten (WL),
- mit einem Adreßbus (3), auf dem eine Adresse (ADR) anlegbar ist, die mehrere Adressbits umfasst, wobei der Adreßbus mehrere Anschlüsse (A0; An) für jeweils eines der Adreßbits umfasst,
- mit mehreren Redundanzschaltungen (1), wobei jede der Redundanzschaltungen jeweils einer der redundanten Einheiten (RWL0; RWL2) zugeordnet ist,
- bei dem die mehreren Redundanzschaltungen (1) jeweils zum Speichern einer Adresse der durch die jeweilige redundante Einheit (RWL1) zu ersetzenden normalen Einheit (WL), zum Vergleichen der auf dem Adreßbus (3) anliegenden Adresse (ADR) mit der gespeicherten Adresse und zur Auswahl der jeweiligen redundanten Einheit (RWL1) bei festgestellter Übereinstimmung mit dem Adreßbus (3) verbunden sind, ,
- bei dem jede der Redundanzschaltungen (1) mehrere Eingänge (E0; En) für jeweils eines der Adreßbits aufweist,
**dadurch gekennzeichnet, dass**
jeder der Redundanzschaltungen (1) jeweils eine Verarbeitungseinheit (2) zugeordnet ist, wobei jede der Verarbeitungseinheiten (2) eingangsseitig mit einem unterschiedichen Anschluß (A0; An) des Adressbusses (3) und mit einem Anschluß für ein Testsignal (TM) verbunden ist und ausgangsseitig mit einem unterschiedlichen Eingang (E0; En) der Redundanzschaltungen verbunden ist, wobei die jeweilige Verarbeitungseinheit (2) das ihr über den Anschluß des Adreßbusses zugeführte Adresssignal nur bei einem definierten Zustand des Testsignals verändert.

2. Integrierter Halbleiterspeicher nach Anspruch 1,
**dadurch gekennzeichnet, daß**
- jede der Redundanzschaltungen (1) Speicherschaltungen (4) entsprechend der Anzahl der Adreßbits enthält, die jeweils ein programmierbares Element (F) aufweisen,
- jede der Speicherschaltungen (4) wenigstens einen Eingang (42) aufweist, der mit einem der Eingänge (E0; En) der Redundanzschaltung (1) verbunden ist.

3. Integrierter Halbleiterspeicher nach Anspruch 2,
**dadurch gekennzeichnet, daß**
jede der Redundanzschaltungen (1) eine weitere Speicherschaltung (5) mit einem programmierbaren Element (F) aufweist, die Information darüber enthält, ob die in den Speicherschaltungen (4) gespeicherte Information gültig ist.

4. Integrierter Halbleiterspeicher nach Anspruch 3,
**dadurch gekennzeichnet, daß**
die weitere Speicherschaltung (5) wenigstens einen Eingang (52) aufweist, der mit einem Anschluß für das Testsignal (TM) verbunden ist.

5. Integrierter Halbleiterspeicher nach einem der Ansprüche 2 bis 4,
**dadurch gekennzeichnet, daß**
jede der Speicherschaltungen (4, 5) jeweils einen Eingang (42, 52) für ein logisches Signal (At, TMt) und einen Eingang (41, 51) für ein dazu komplementäres (Ac, TMc) logisches Signal aufweist.

6. Integrierter Halbleiterspeicher nach Anspruch 5,
**dadurch gekennzeichnet, daß**
jede der Speicherschaltungen (4, 5) jeweils einen Ausgang (43, 53) aufweist für ein Ausgangssignal (HIT), das
- bei einem programmierten programmierbaren Element (F) den Zustand des komplementären logischen Signals (Ac, TMc) und
- bei einem nicht programmierten programmierbaren Element (F) den Zustand des logischen Signals aufweist (At, TMt).

7. Integrierter Halbleiterspeicher nach einem der Ansprüche 2 bis 6,
**dadurch gekennzeichnet, daß**
das programmierbare Element (F) eine Laser Fuse enthält.

## Claims

1. Integrated semiconductor memory, comprising:
- memory cells (MC), which are combined to form addressable normal units (WL),
- a plurality of redundant units (RWLO; RWL2) for replacing normal units (WL),
- an address bus (3), to which an address (ADR) comprising a plurality of address bits can be applied, where the address bus comprises a plurality of connections (A0; An) for a respective one of the address bits,
- a plurality of redundancy circuits (1), where each of the redundancy circuits is associated with a respective one of the redundant units (RWLO; RWL2),
- wherein the plurality of redundancy circuits (1) are respectively connected to the address bus (3) for storing an address for the normal unit (WL) which is to be replaced by the respective redundant unit (RWL1), for comparing the address (ADR) which is on the address bus (3) with the stored address, and for selecting the respective redundant unit (RWL1) if a match is established,
- wherein each of the redundancy circuits (1) has a plurality of inputs (E0; En) for a respective one of the address bits,
**characterized in that**
each of the redundancy circuits (1) has a respective associated processing unit (2), each of the processing units (2) being connected at the input to a different connection (A0; An) of the address bus (3) and to a connection for a test signal (TM) and being connected at the output to a different input (E0; En) of the redundancy circuit, where the respective processing unit (2) modifies the address signal supplied thereto via the connection of the address bus only for a defined state of the test signal.

2. Integrated semiconductor memory according to Claim 1, **characterized in that**
- each of the redundancy circuits (1) contains memory circuits (4) according to the number of address bits, each of the memory circuits having a programmable element (F),
- each of the memory circuits (4) has at least one input (42) which is connected to one of the inputs (E0; En) of the redundancy circuit (1).

3. Integrated semiconductor memory according to Claim 2, **characterized in that**
each of the redundancy circuits (1) has a further memory circuit (5) with a programmable element (F), said further memory circuit containing information about whether the information stored in the memory circuits (4) is valid.

4. Integrated semiconductor memory according to Claim 3, **characterized in that**
the further memory circuit (5) has at least one input (52) which is connected to a connection for the test signal (TM).

5. Integrated semiconductor memory according to one of Claims 2 to 4,
**characterized in that**
each of the memory circuits (4, 5) has a respective input (42, 52) for a logic signal (At, TMt) and an input (41, 51) for a logic signal (Ac, TMc) which is the complement thereof.

6. Integrated semiconductor memory according to Claim 5, **characterized in that**
each of the memory circuits (4, 5) has a respective output (43, 53) for an output signal (HIT) which has
- the state of the complementary logic signal (Ac, TMc) when a programmable element (F) has been programmed, and
- the state of the logic signal (At, TMt) when a programmable element (F) has not been programmed.

7. Integrated semiconductor memory according to one of Claims 2 to 6,
**characterized in that**
the programmable element (F) contains a laser fuse.

## Revendications

1. Mémoire à semi-conducteur intégrée
- comprenant des cellules (MC) de mémoire, qui sont rassemblées en des unités (WL) normales pouvant être adressées,
- comprenant plusieurs unités (RWLO ; RWL2) redondantes pour remplacer des unités (WL) normales,
- comprenant un bus (3) d'adresse, sur lequel une adresse (ADR) peut être mise, adresse qui comprend plusieurs bits d'adresse, le bus d'adresse comprenant plusieurs bornes (A0 ; An) pour respectivement l'un des bits d'adresse,
- comprenant plusieurs circuits (1) redondants, chacun des circuits redondants étant associé respectivement à l'une des unités (RWL0 ; RWL2) redondantes,
- dans laquelle les plusieurs circuits (1) redondants sont reliés respectivement, pour mémoriser une adresse de l'unité (WL) normale à remplacer par l'unité (RWL1) redondante respective, pour comparer l'adresse (ADR) se trouvant sur le bus (3) d'adresse à l'adresse mémorisée et pour sélectionner l'unité (RWL1) redondante respective lorsqu'une coïncidence avec le bus (3) d'adresse est établie,
- dans laquelle chacun des circuits (1) redondants a plusieurs entrées (E0 ; En) pour respectivement l'un des bus d'adresse,
**caractérisée en ce que**
à chacun des circuits (1) redondants est associée respectivement une unité (2) de traitement, chacune des unités (2) de traitement étant reliée du côté de l'entrée à une borne (A0 ; An) différente du bus (3) d'adresse et à une borne pour un signal (TM) de test et du côté de la sortie à une entrée (E0 ; En) différente des circuits redondants, l'unité (2) de traitement respective ne modifiant le signal d'adresse qui lui est envoyé par la borne du bus d'adresse que pour un état défini du signal de test.

2. Mémoire à semi-conducteur intégrée suivant la revendication 1,
**caractérisée en ce que**
- chacun des circuits (1) redondants comporte des circuits (4) de mémoire correspondant au nombre des bits d'adresse qui ont, respectivement, un élément (F) programmable,
- chacun des circuits (4) de mémoire a au moins une entrée (42) qui est reliée à l'une des entrées (E0 ; En) du circuit (1) redondant.

3. Mémoire à semi-conducteur intégrée suivant la revendication 2,
**caractérisée en ce que**
chacun des circuits (1) redondants a un autre circuit (5) de mémoire ayant un élément (F) programmable qui comporte de l'information sur le point de savoir si l'information mémorisée dans les circuits (4) de mémoire est valable.

4. Mémoire à semi-conducteur intégrée suivant la revendication 3,
**caractérisée en ce que**
l'autre circuit (5) de mémoire au moins une entrée (52) qui est reliée à une borne pour le signal (TM)de test.

5. Mémoire à semi-conducteur intégrée suivant l'une des revendications 2 à 4,
**caractérisée en ce que**
chacun des circuits (4, 5) de mémoire a respectivement une entrée (42, 52) pour un signal (At, TMt) logique et une entrée (41, 51) pour un signal logique complémentaire (Ac, TMc) de celui-ci.

6. Mémoire à semi-conducteur intégrée suivant la revendication 5,
**caractérisée en ce que**
chacun des circuits (4, 5) de mémoire a respectivement une sortie (43, 53) pour un signal (HIT) de sortie, qui,
- lorsqu'un élément (F) programmable est programmé, a l'état du signal (Ac, TMc) logique complémentaire et
- lorsqu'un élément (F) programmable n'est pas programmé, a l'état du signal logique (At, TMt).

7. Mémoire à semi-conducteur intégrée suivant l'une des revendications 2 à 6,
**caractérisée en ce que**
l'élément (F) programmable comporte un fusible laser.
